# NEW EUROPEAN PATENT SPECIFICATION

(11) **EP 0 465 562 B2**
(45) Date of publication and mention of the opposition decision: **12.01.2000**
(45) Mention of the grant of the patent: 05.03.1997
(21) Application number: 90905861.2
(22) Date of filing: 30.03.1990
(51) Int. Cl.: B41M 5/24, G03F 3/10

(54) **A NEAR INFRARED LASER ABSORBING COATING AND METHOD FOR USING SAME IN COLOR IMAGING AND PROOFING**
IM NAHEN UV-BEREICH ARBEITENDEN LASER ABSORBIERENDE BESCHICHTUNG SOWIE GEBRAUCH DERSELBEN IN DER HERSTELLUNG VON FARBBILDERN UND PRÜFFOLIEN
REVETEMENT ABSORBANT DES LASERS INFRAROUGES PROCHES ET SON PROCEDE D'UTILISATION EN MISE EN IMAGES ET TIRAGE EN COULEURS

(30) Priority: 30.03.1989 US 330497; 23.03.1990 US 497648
(43) Date of publication of application: 15.01.1992
(73) Proprietor: POLAROID CORPORATION, Cambridge, Massachusetts 02139 (US)
(72) Inventor: FOLEY, Diane, M., Northampton, MA 01060 (US); BENNETT, Everett, W., Easthampton, MA 10127 (US); SLIFKIN, Sam, C., deceased (US)
(74) Representative: Kraus, Walter, Dr.
(86) International application number: US9001635
(87) International publication number: WO9012342

(56) References cited:
- EP-A- 0 157 568
- WO-A-90/12342
- GB-A- 2 176 018
- JP-A- 5 188 016
- JP-A- 5 646 789
- JP-A- 5 714 095
- US-A- 3 745 235
- US-A- 3 780 214
- US-A- 4 501 808
- US-A- 4 514 493
- US-A- 4 551 413
- US-A- 4 629 670
- US-A- 4 634 652
- US-A- 4 707 427
- US-A- 4 725 519
- US-A- 4 857 431

## Description

### BACKGROUND OF THE INVENTION

The present invention relates to a laser imaging material which includes a near infrared laser absorbing coating composition and color imaging and proofing methods using the material.

The laser induced ablative imaging of a material having an imaging layer thereon is known in the art. Ablative imaging is a material transfer process in which laser radiation causes rapid local changes in the imaging layer thereby causing the loss of material, for example, ejecting material from the layer. Ablation as described herein is distinguished from other material transfer techniques in that some degree of a chemical (i.e., bond breaking) rather than a completely physical (i.e., melt/flow, evaporation, sublimation) change causes the transfer and in that an essentially complete transfer of material rather than partial transfer occurs.

In order for ablation to occur, one or more of the components in the imaging layer must effectively absorb laser light. At short wavelengths (i.e., less than 300 nm), many organic materials are strongly absorbing. Therefore, 193 nm and 248 nm eximer lasers are commonly used in laboratory research into the photoablation of polymers.

However, due to the economics involved in commercial practice, the use of visible (380-760 nm) and near IR (760-3000 nm) lasers is much more desirable. Unfortunately few polymers have significant absorption in the visible and fewer still absorb in the near IR. This deficiency has been overcome by adding dispersed or soluble materials absorbing at the desired wavelengths to the polymers. See, for example, the discussion in the T.J. Chuang et al article in Applied Physics, Vol. 45, pgs. 277-288 (1988) which is incorporated herein by reference.

This strategy is often used in information recording with the visible diode lasers emitting at wavelengths of 760 to 850 nm. See, for example, U.S. Patents 4,415,621; 4,446,233; 4,582,776; and 4,809,022 and the N. Shimadzu et al article in the Journal of Imaging Technology, Vol. 15, No. 1, page 19 (1989).

Currently available power densities and dwell times used in information recording for optical disks are sufficient to cause polymer melting and flow, but insufficient to generate the extreme force of polymer decomposition necessary to transfer large amounts of inert materials to an adjacent surface. One laser in commercial practice which does supply sufficient power density (about 10⁶ watts/cm² vs. about 10³ watts/cm² for laser diodes) is the Crosfield Datrax Nd:YAG laser emitting at 1064 nm. Ablation imaging at 1064 nm has been described. Infrared absorbers which are used in absorbing layers for use with, for example, a near IR 1064 nm laser include black body materials such as: graphite, see, for example, U.S. Patents 4,702,958 and 4,711,834; carbon black, see, for example, U.S. Patent 4,588,674; and a combination of graphite with small amounts of Cyasorb IR 165, 126, or 99, as in Great Britain Patent 2,176,018A.

In the absorbing layer, the absorbers are usually dispersed in a commercially available polymeric binder including a self oxidizing binder such as nitrocellulose, or a non-self oxidizing binder such as ethylcellulose, acrylic resins, polymethylmethacrylate, polymethacrylate, polystyrene, phenolic resins, polyvinylchloride, vinyl chloride/vinyl acetate copolymers, cellulose acetate butyrate, and the like. In measurements by differential scanning calorimetry (DSC), each of the above polymeric binders has a decomposition temperature which is greater than 200°C, except for nitrocellulose which undergoes thermal decomposition at about 180°-210°C.

Because the graphite and carbon black absorbers are highly absorbing throughout the IR, visible and UV regions, the resulting films are useful only when a black image is desired.

In the past, such laser imaging materials have been used as an intermediate film in printing plate production within the printing industry. In this method, the materials which are imaged with a laser provide a negative which can be used as a master to expose plates for printing. A receptor sheet which receives the inert materials from the coating upon ablation, is thus a reversal image or positive which can be used as a black and white proof or print. However, for the reasons discussed above the previously described materials are entirely ineffective for color imaging.

Therefore, the need still exists for a cost effective laser ablatable coating which is inherently substantially colorless in the visible region and thus, can be effective in areas such as color proofing in the printing industry and other laser-addressable ablation transfer color printing systems.

Accordingly, it is an object of the present invention to provide a laser-ablatable coating layer which can be tuned to a variety of laser output wavelengths by choice of the appropriate sensitizers to absorb the radiation and also cause the decomposition leading to ablation and which contains additional materials depending on the function of the product which are transferred during the ablation process to a receiver sheet. The imaged film, the receiver sheet or both may be of interest to the final product.

Further, it is an object of the present invention to sensitize the coating layer to laser wavelengths sufficiently different from the visible region to allow for substantially transparent coatings to which visible colorants may be added without affecting their color purity. An example of such a laser in commercial practice is a Nd:YAG laser emitting light at 1064 nm employed in the imaging hardware of a Crosfield Datrax 765.

It is still a further object of the present invention to provide a near infrared (IR) sensitive ablative layer which is transparent in the visible range so that ultraviolet (UV), visible, and/or near IR absorbing dyes and/or pigments may be added to the coating layer.

These and further objects will become apparent from the specification and claims that follow.

### SUMMARY OF THE INVENTION

In accordance with the foregoing objectives, the present invention relates to a method for transferring a contrasting pattern of intelligence from an ablation-transfer imaging medium to a receptor element in contiguous registration therewith, said ablation-transfer imaging medium comprising a support substrate and a laser radiation-ablative topcoat essentially coextensive therewith, said essentially coextensive topcoat comprising an effective ablative-transfer effecting amount of a non-black body, non-imaging sensitizer that absorbs near infrared radiation at a rate sufficient to effect the image-wise ablation mass transfer of said topcoat, and said laser radiation-ablative topcoat including at least one decomposable binder and an imaging amount of a non-black body, non-ablation sensitizing contrast imaging material contained therein, which method comprises imagewise photoirradiating said ablation-transfer imaging medium according to such pattern of intelligence with near infrared radiation at an intensity sufficient to effect the ablation mass transfer of the volume of the imagewise-exposed area of the laser radiation-ablative topcoat of said imaging medium securedly onto said receptor element including mass transfer onto said receptor element of the non-ablation sensitizing contrast imaging material contained therein, and whereby said transferred contrast imaging material delineates said pattern of intelligence thereon.

In particular, the coating or coated layer used in the present invention comprises at least one sensitizer which absorbs at the wavelength of the desired laser output in the near infrared region of 760 nm to 3,000 nm, and at least one decomposable binder. The at least one sensitizer is present in an amount effective to allow the rapid partial decomposition of the at least one binder when the at least one sensitizer interacts with laser light. The decomposable binder comprises those polymeric materials which undergo rapid acid catalyzed decomposition, preferably at temperatures less than 200°C. The coating may also, optionally, contain materials which are non-absorbing at the wavelength of the desired laser output and/or non-decomposing as well as optimal amounts of commercially available binders which are not decomposable binders in the imaging process. In a preferred embodiment, the coating comprises at least one near infrared sensitizer, at least one decomposable binder, and at least one hydrogen atom donating material.

In another aspect of the present invention, there is provided an ablation-transfer imaging medium, which comprises a support substrate and a non-laser radiation-reflecting, laser radiation-ablative topcoat essentially coextensive therewith, said essentially coextensive topcoat comprising an effective ablative-transfer effecting amount of a non-black body, non-imaging sensitizer that absorbs but does not reflect near infrared radiation at a rate sufficient to effect the imagewise ablation mass transfer of said topcoat, and said imaging radiation-ablative topcoat including at least one decomposable binder and an imaging amount of a non-black body, non-ablation sensitizing contrast imaging material contained therein.

In another aspect of the present invention, there is provided an organization adopted for transferring a contrasting pattern of intelligence from an ablation-transfer imaging medium to a receptor element, comprising (1) an ablation-transfer imaging medium which comprises a support substrate and a non-laser radiation-reflecting, laser radiation-ablative topcoat essentially coextensive therewith, said essentially coextensive topcoat comprising an effective ablative-transfer effecting amount of a non-black body, non-imaging sensitizer that absorbs but does not reflect near infrared radiation at a rate sufficient to effect the imagewise ablation mass transfer of said topcoat, and said laser radiation-ablative topcoat including at least one decomposable binder and an imaging amount of a non-black body, non-ablation sensitizing contrast imaging material contained therein, and (2) a receptor element in contiguous registration therewith.

In another aspect of the present invention, there is provided a system for transferring a contrasting pattern of intelligence from an ablation-transfer imaging medium to a receptor element, comprising the organization as defined above and means for selectively irradiating one face surface of said ablation-transfer imaging medium with a beam of laser radiation corresponding to said pattern of intelligence.

### BRIEF DESCRIPTION OF THE DRAWINGS

Fig. 1 illustrates one embodiment of the method of the present invention employing near infrared transparent supports.
Fig. 2 illustrates a second embodiment of the method of the present invention employing near infrared non-transparent supports.

### DETAILED DESCRIPTION OF THE PREFERRED EMBODIMENTS

The coating composition comprises a solution or dispersion containing at least one near infrared sensitizer and a decomposable binder.

The absorbing sensitizers which can be used in the present invention include any material which can absorb at a desired wavelength for a particular near infrared laser output and which preferably can initiate acid formation. In particular, when visibly transparent coatings are required, for example, substituted aromatic diamine dication-type sensitizers absorbing at 1064 nm and having counterions derived from strong acids are preferred. Examples of such sensitizers are: 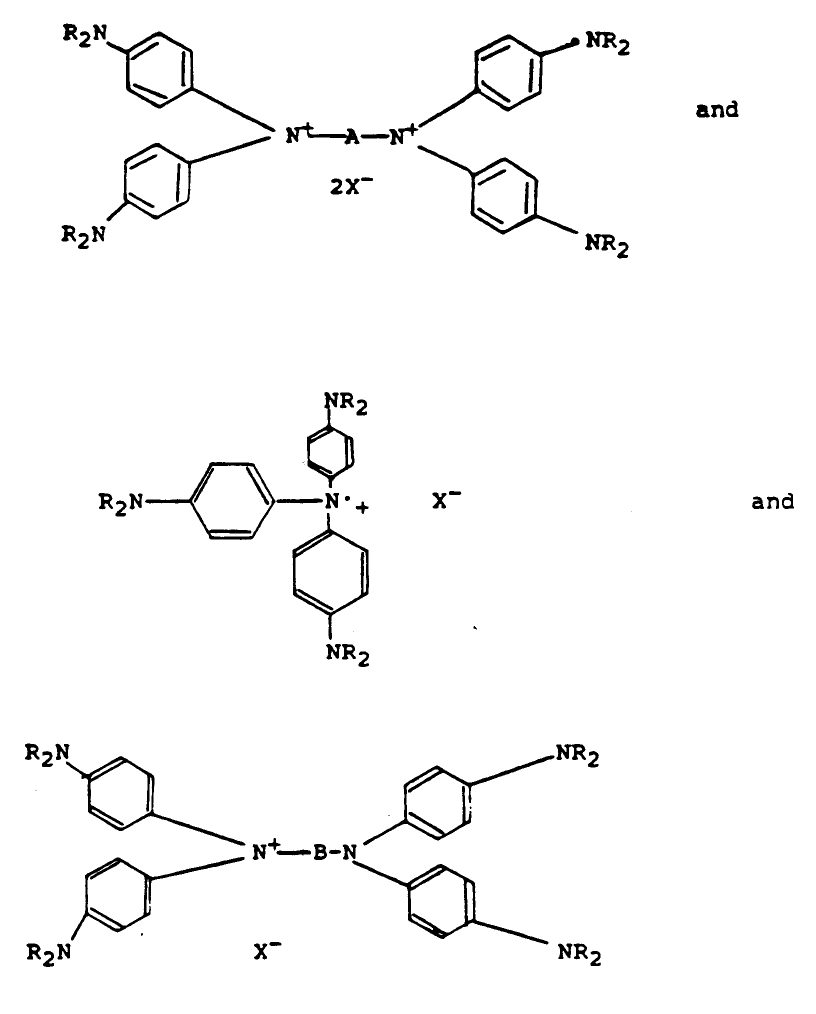 where
R = alkyl, benzyl, substituted benzyl etc.
X = SbF₆⁻, BF₄⁻, PF₆⁻, AsF₆⁻, ClO₄⁻, B(phenyl)₄, triflate and other salts of strong acids which are not capable of electron donation to the cation radical or dication radical in the ground state;
A = 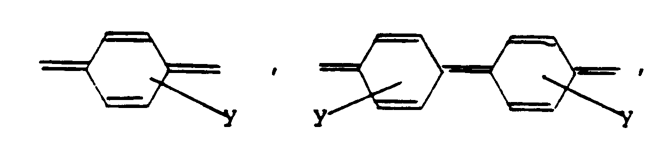
B = 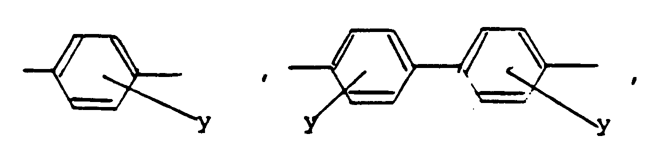
Y = hydrogen, alkyl, aryl, nitro, halo, benzyl, substituted benzyl, etc.

Examples of these sensitizers include the series of near infrared absorbers which go by the trade name Cyasorb IR 165, 126 and 99 from American Cyanamid as well as those IR absorbers described in U.S. Patent 4,656,121 which is incorporated herein by reference.

Furthermore, in general other sensitizers which can be employed include any cation radical and dication radical salts of strong acids which absorb strongly at the desired laser output wavelength. While an output wavelength of 1064 nm is preferred in certain color imaging and proofing applications, any wavelength can be employed where sufficient power is present to be effective for the desired application. The decomposable binders according to the present invention are those polymeric materials which undergo rapid acid catalyzed decomposition, preferably at temperatures less than about 200°C, and most preferably at temperatures less than about 100°C.

In particular, decomposable binders for use in this invention are those binders which decompose rapidly to give significant amounts of gases and volatile fragments at temperatures less than about 200°C and undergo significant reduction of decomposition temperature in the presence of small amounts of acids. Most desirable is the lowering of the decomposition temperature to less than about 100°C.

Examples of such polymers are nitrocellulose, polycarbonates, and materials of the type described in J.M.J. Frechet, F. Bouchard, F.M. Houlihan, B. Kryczke, E. Eichler, J. Imaging Science; 30(2) 59-64 (1986), and related materials which are described in detail in the balance of this disclosure.

Examples of binders include polycarbonates having the structure: 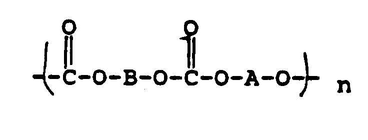 where B comprises 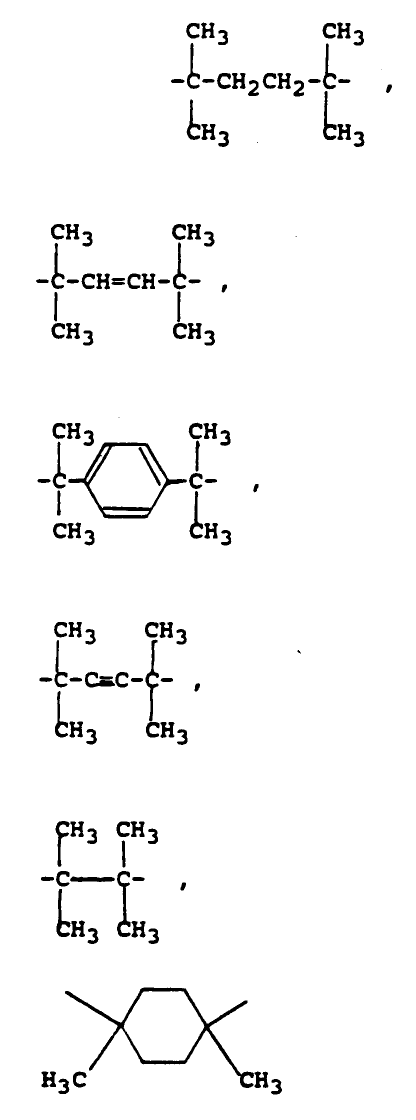 or other groups capable of generating a tertiary carbonium ion upon thermolysis and of producing gain or amplification in the decomposition of the polymer by eliminating a proton from the carbonium ion.

In other words, in addition to a thermal decomposition, as illustrated in the model system below: 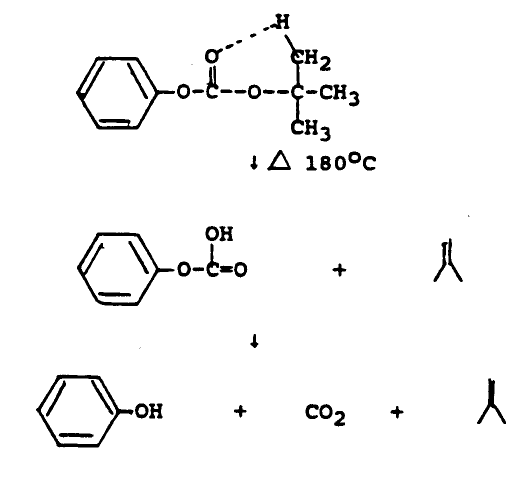 the present invention preferably employs an acid catalyzed thermal decomposition, 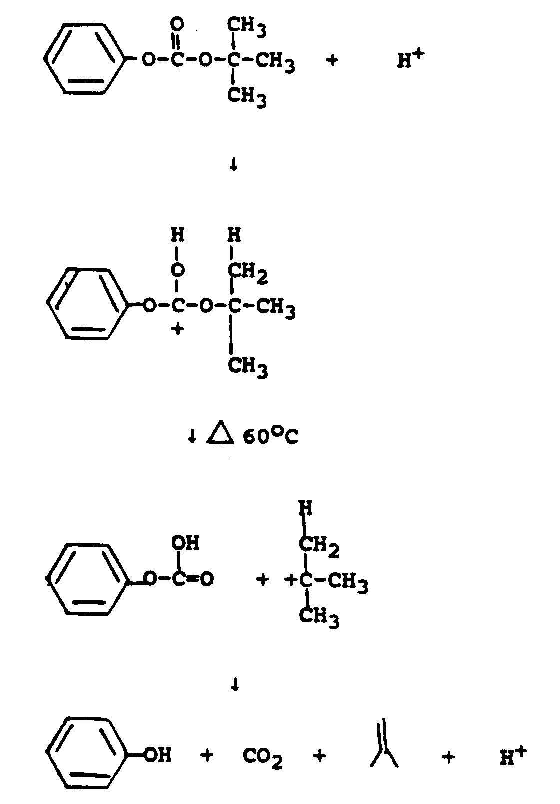 as generally described by JMJ Frechet, et al, Journal of Imaging Science, 30(2)59(1986). Commercially available Bisphenol A polycarbonate decomposes at temperatures greater than 300°C. Non tertiary diols and polyols may be polymerized in combination with tertiary diols to improve the physical properties of the polymer.

A may be the same as B or chosen from those dihydroxy aromatic or poly hydroxy compounds capable of polymerization to a polycarbonate. 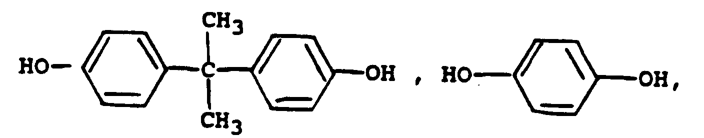 are preferred.

The synthesis of these polymers has been described, for example, by JMJ Frechet et al, Polymer Journal, 19(1), pp. 31-49, (1987).

In addition to the polycarbonates, polyurethanes of the following general structure can also be employed: 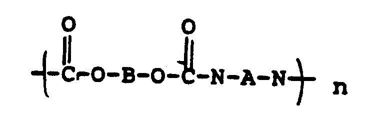 where B is as described above and A is chosen from those aromatic or aliphatic diisocyanate or polyisocyanates capable of copolymerization with the above tertiary diols to give a polyurethane. 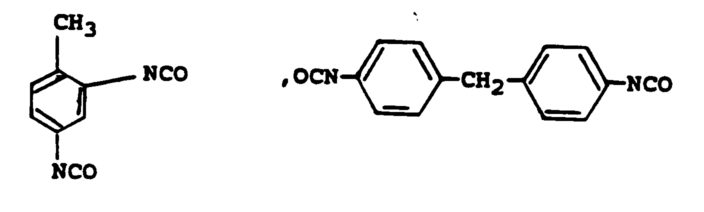 are preferred.

It is known that polyurethanes of primary and secondary diols and polyols decompose at temperatures greater than about 200°C: 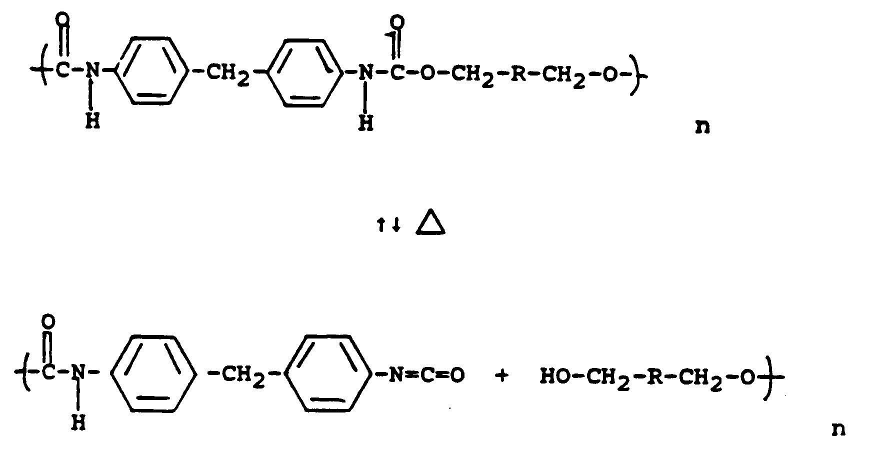 where R is alkyl.

However, polyurethanes containing certain tertiary alcohol structural units can decompose at less than about 200°C by cleavage in a mechanism analogous to that of Frechet's polycarbonates as illustrated below:

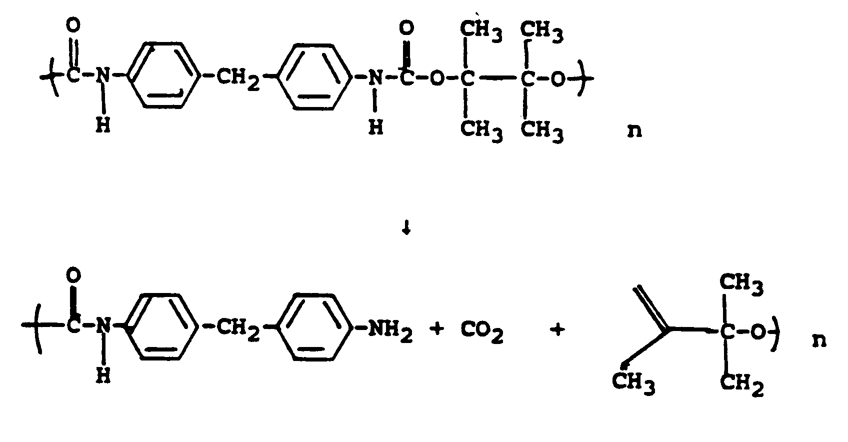

Similar to the case with polycarbonates illustrated previously, the present invention preferably employs an acid catalyzed thermal decomposition with polyurethanes.

Small amounts (less than about 10%) of non-tertiary diols and polyols may be polymerized in combination with the tertiary diols to improve the physical properties of polymer.

The synthesis of these polyurethanes is shown within Example 1, infra.

In addition to polycarbonates, and polyurethanes, polyesters of the following general structure may be employed: 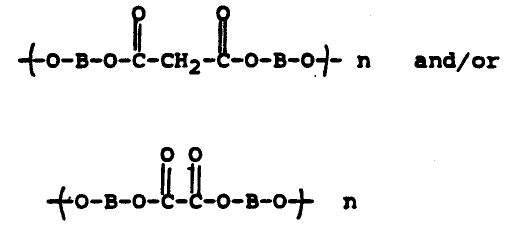 where B is described above. Polyorthoesters and polyacetals with analogous general structures may also be employed.

Small amounts (e.g., less that about 10%) of non-tertiary diols and polyols may be polymerized in combination with B to improve the physical properties of the polymer.

Small amounts (e.g., less than about 10%) of other compatible di- and polyacids may be polymerized in combination with malonic and oxalic acid to improve the physical properties of the polymer.

Alternating block copolymers containing polycarbonate, polyurethane, and/or polyester units as described above, as well as containing analogous polyorthoester and polyacetal units, may also be employed.

Examples of other polymers which are effective in the present invention include nitrocellulose with low viscosity, SS nitrocellulose being particularly preferred. Other examples of nitrocellulose which can be employed are described on pages 329-336 in Cellulose and Its Derivatives by Ister and Flegien which is incorporated herein by reference.

In addition, nitrocellulose can be added in the form of nitrocellulose containing printing inks which are compatible with the solvent used to dissolve the sensitizer. Examples of such compositions include solvent based gravure inks and process printing inks. In addition, the nitrocellulose can be used alone or can be employed with other decomposable binders.

As was previously discussed, the binder employed ideally is soluble within the same solvent which dissolves the near infrared absorbing sensitizer. However, dispersions may be used in appropriate circumstances when a mutual solvent cannot be found.

The coating composition may also contain other materials which are non-absorbing at the desired laser emission wavelengths and/or non-decomposing and do not adversely affect the absorbance of the coating at the laser wavelength. These materials are chosen dependant upon the function of the final product to be produced. These materials may play a part in the imaging chemistry or may be inert.

In a preferred embodiment, substances believed capable of donating H· (hydrogen atom) to the excited state of the sensitizer are included in the coating compositions, thereby increasing acid formation. Such materials include alcohols, thiols, phenols, amines, and hydrocarbons. Particularly preferred are low molecular weight secondary and tertiary alcohols, diols and polyols such as 1,2-decanediol, pinacol, 2,5-dimethylhexane-2,5 diol, 2,5-dimethyl-3-hexyne-2,5-diol and combinations of these. Addition of the hydrogen atom donors to the coating surprisingly enables the reduction of the amount of costly near IR absorber(s) from about 50% by weight based on solids to about 5 to about 15% by weight based on solids.

However, when nitrocellulose is employed as the polymeric binder, the use of an additional hydrogen atom donor material is not required because the desired hydrogen donors are already present within the resin. Such additional material may be nonetheless added if desired.

Examples of additions which also may be included are chosen dependent on the functions of the final product to be produced. The combined use of at least one hydrogen atom donating material and at least one additive is particularly preferred within the present invention.

When employing a laser having an output at 1064 nm wavelength, these additives can include visible or UV absorbing materials particularly those commonly used in the printing industry such as C.I. Blue 15, C.I. Yellow 17, C.I. Magenta 57, C.I. Black 7 or actual solvent based printing inks such as those available from American Inks and Coatings Co., plasticizers, surfactants, adhesion promoters and the like. Particularly preferred are dyes such as Morfast Brown 100, Morfast Violet 1001, Morfast Blue 105, Morfast Yellow 101, and Morfast Red 104 due to their high tinctorial strength (Morfast is a trademark of Morton Thiokol for a series of liquid dyes). In addition, when nitrocellulose is employed as the binder, the previously discussed nitrocellulose containing printing inks are preferred.

In terms of the coating, the sensitizer and decomposable binder are present in amounts sufficient to allow rapid partial decomposition of the binder to gaseous and non-gaseous products when the sensitizer interacts with laser light. Preferably, the decomposable binder is present in an amount of about 50 to about 95% by weight of dry solids while the sensitizer is present in an amount of about 5 to about 50% by weight of dry solids. In addition, the additives can be present in an amount of about 0.5 to about 50% by weight of dry solids while the hydrogen atom donor can be present in an amount of about 1 to about 10% by weight of dry solids.

In producing the coating composition a solution or dispersion is made which contains solvent, the near infrared absorbing sensitizer, the decomposable binder and, optionally, the hydrogen atom donor and/or additives. Preferably, the components of the wet coating are present in amounts of about 0.2 to about 5% by weight of the absorbing sensitizer, about 0.5 to about 20% by weight of the decomposable binder and, optionally, about 0.5 to about 2% by weight of a hydrogen atom donor and/or about 2 to about 20% by weight of the additives, with the remainder being solvent.

The solvent employed in the present invention includes those solvents which dissolve both the binders and preferably the near IR sensitizers. Examples of such solvents include chlorinated hydrocarbons, such as methylene chloride, 1,1,1-trichlorethane, chloroform, carbon tetrachloride, trichloromethane and the like; ketones such as acetone, methyl ethylketone, methyl propylketone and higher boiling analogues whose boiling points do not exceed the thermal decomposition thresholds of the binder resin, or mixtures thereof.

After the solution or dispersion is made, it is coated onto the support film by methods which are well-known in the art such as Meyer rod coating, gravure coating, reverse roll coating or extrusion coating. Because they are well known in the art, they are not further explained here.

The support films employed can be either near infrared transparent support films or near infrared non-transparent support films. Transparent support films which can be employed by the present invention include polyesters, polycarbonates and any base which does not dissolve in the coating solvents employed, with polyesters being preferred. Examples of non-transparent support includes any non-transparent base which would not dissolve in the coating solvents employed. These supports can include aluminum supports, such as used in printing plates, glass substrates, and silicon chips.

The coating is preferably employed in the amount of about 0.1 to about 0.5 grams dry wt/ft² and absorbance at 1064 nm of not less than 0.125.

When the sensitizer is chosen so as to be substantially non-absorbing in the visible region (400-760 nm), the laser imaging materials of the present invention can be advantageously employed in a color imaging and proofing method. By this method, a receptor sheet is positioned and firmly held as in a vacuum frame relative to the above described laser imaging material in such a manner that it is effective in receiving materials which have been ablated from the surface of the imaging material.

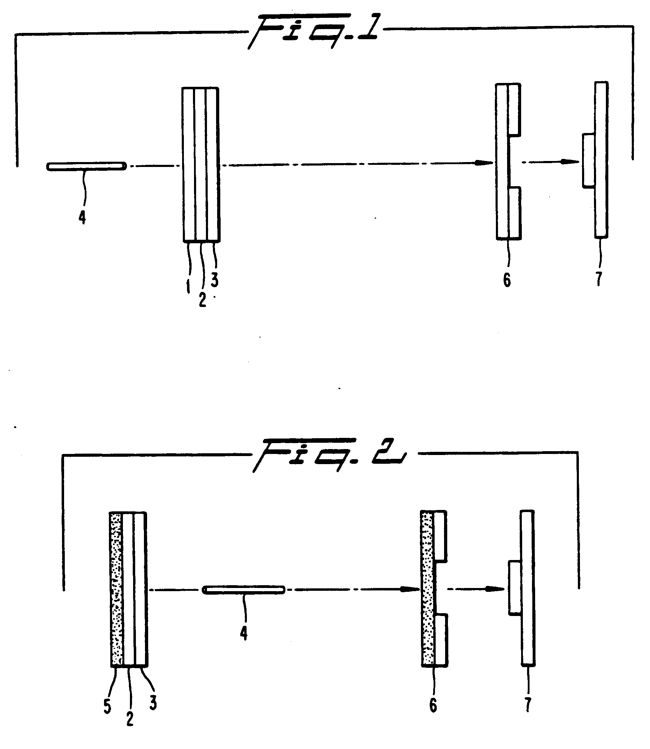

Figure 1 illustrates the use of near infrared transparent supports in the method of the present invention. In this embodiment, laser beam, 4, contacts the material which comprises the laser transparent support, 1, the laser abatable coating, 2, and the receiver sheet, 3, on the back or support side of the material.

Figure 2 illustrates an alternative embodiment of the present invention wherein the material uses a near infrared nontransparent support 5. In this embodiment the receiver sheet, 3, is made of near infrared transparent material and the laser beam contacts the material on the front or receiver sheet side of the material.

In either embodiment, laser radiation, at the desired wavelength is introduced onto the absorbing layer so as to cause rapid partial decomposition of the binder(s) to gaseous products. The rapid expansion of the heated gases causes ablation of the coating layer to the receptor sheet thus producing an imaged color film or intermediate master, 6, (i.e., the laser donor imaging material) and a color print or proof, 7, (i.e., the receptor sheet).

The receptor sheet employed can include those which are well-known in the art of proofing such as newsprint, coated or uncoated papers of all shades and color, opaque filled, and opaque coated plastic sheets with the printing stock to be employed in the particular color proofing application being preferred. It can also include those which are known in the art of color hard copy printing such as transparent and opaque films and various coated and uncoated papers.

Moreover, because the decomposable binder and sensitizer are transparent in the visible range, materials such as UV, visible and near IR absorbing dyes and/or pigments can be added to the coating. This also allows the material to be used in applications such as color printing and proofing, which prior ablative materials simply could not address.

In order to further illustrate the present invention and the advantages associated therewith, the following specific examples are given, it being understood that same are intended only as illustrative and in nowise limitative.

### EXAMPLE 1

### Polyurethane Synthesis (Polymer VII from Table 1):

2.4-Toluene diisocyanate (TDI), 20g, 2,5-dimethyl-3-hexyne-2,5- diol, 16.3 g., dibutyltin dilaurate, 5 drops and N-methyl pyrrolidone, 50 ml, were added to a 200 ml flask equipped with magnetic stir bar and nitrogen inlet. The solution was stirred 6 hours at 50°C, then at room temperature overnight. The polymer was isolated by precipitation from water. Polymers gave MW ≅ 7,000 by GPC with thermal decomposition at 165°C by DSC (scan rate of 25°C/min).

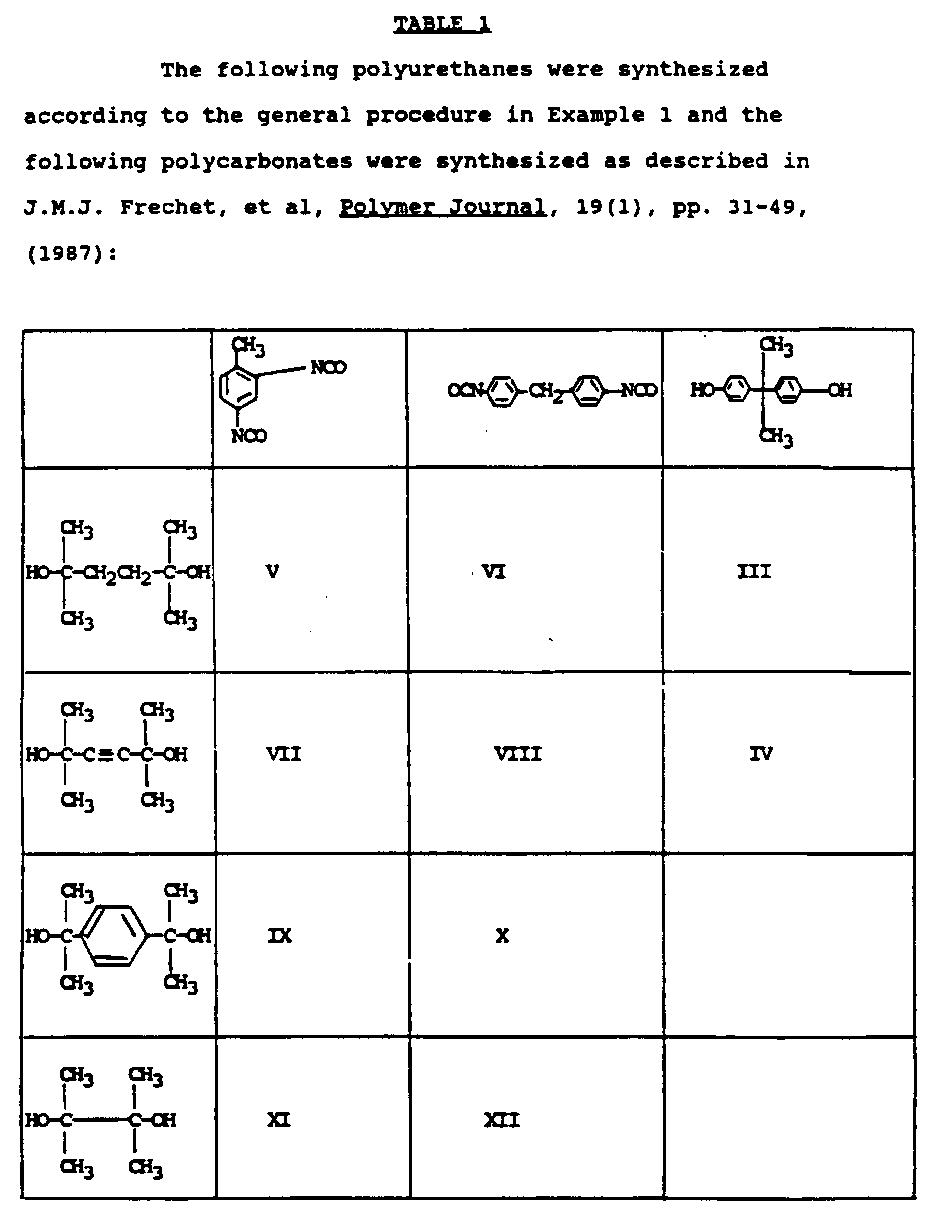

The above polymers were evaluated by DSC.

The following results were obtained:

**TABLE 2**

| POLYMER | SOFT/MELT TEMP.(°C) | MELT ENERGY (J/g) | DECOMPOSITION TEMP. (°C) |
|---|---|---|---|
| III | 139 | 22 | 180 |
| IV | 50 | 21 | 170 |
| V | - | - | 200 |
| VI | - | - | 110 |
| VII | 46 | 85 | 165 |
| VIII | 100 | - | 113 |
| IX | - | - | 157 |
| X | 63 | - | 100 |
| XI | 94 | 22 | 206 |
| XII | 50 | 100 | 174 |
| Ethyl cellulose | 96 | 17 | 203 |
| Polyacetal | - | - | 171 |

### EXAMPLE 2

The following solution was made and coated on polyester film with #4 Meyer rod at a loading of 0.5g wet weight/ft². Addition of components was in the order indicated:
- 7.25g: Acetone
- 1.197g: Copolymer of 2,4 TDI & 2,5-dimethyl-3-hexyne-2,5-diol (Polymer VII from Table 1)
- 0.364g: Cyasorb IR 165
- 0.12g: 2,5-Dimethyl-3-hexyne-2,5-diol
- 1.06g: Morfast Yellow 101
The yellow film was imaged using a yellow separation film master on the Crosfield Datrax 765 at 9.8 W (0.16J/cm²) to give an imaged yellow film and a reversal yellow print on a newsprint receptor sheet. The Datrax 765 is commercial laser imaging hardware from Crosfield Electronics, Ltd. which employs a 1064 nm Nd:YAG laser with 5-15W of available power:

### EXAMPLE 3

The above solution was made substituting a combination of 0.76g Morfast Red 104 and 0.04 g Morfast Brown Violet 1001 in place of Morfast Yellow in Example 2. The films were imaged using a magenta separation film master as above with the yellow print on newsprint from Example 2 used as receptor sheet to produce a two color print along with an imaged magenta film.

### EXAMPLE 4

The above solution was made substituting a combination of 0.4g Morfast Blue 105 and 0.4g Morfast Brown 100 in place of Morfast Yellow in Example 2. The films were imaged onto the above two color print receptor sheet from Example 3 using a cyan film master to give a three color print along with an imaged cyan film.

### EXAMPLE 5

The above solution was made substituting a combination of Morfast Brown 100 and Morfast Blue 105 and Morfast Red 104 (total weight of 1.06g in place of Morfast Yellow in Example 2) color balanced to give a neutral black film. The films were imaged using a black separation master onto the three color print receptor sheet from Example 4 to give a full color print suitable for color proofing along with an imaged neutral black film.

### EXAMPLE 6

The following solution was made and coated as described in Examples 2 through 5.
- 7.25 g: Acetone
- 0.364g: Cyasorb IR 165
- 2.5g: American Ink & Coatings Co.
gravure inks
Process Yellow or
Process Red or
Process Blue or
Process Black.

The American Ink gravure inks include nitrocellulose which is the decomposable binder. Films are imaged as described in Examples 2 through 5 to give full color prints along with individual imaged monocolor and black films.

### EXAMPLE 7

The following solution is made and coated as described in Examples 2 through 5.
- 7.25 g: Acetone
- 1.197 g: Copolymer of 4,4'diphenyl methane diisocyanate and PARADIOL (trade name of Goodyear Chemicals) (Polymer X from Table 1)
- 0.364g: Cyasorb IR 165
- 0.12g: 2,5-Dimethyl-3-hexyne-2,5-diol
- 2.5g: American Ink & Coatings Co.
gravure inks
Process Yellow or
Process Red or
Process Blue or
Process Black.
Films are imaged as described in Examples 2 through 5 to give full color prints along with individual imaged monocolor and black films.

### EXAMPLE 8

To 8.35g of a 50:50 mixture of 1,1,1-trichloroethane and methylene chloride is added 0.5g of an alternating polycarbonate synthesized from Bisphenol A and 2,5-dimethyl hexane-2,5-diol (Polymer III from Table 1); 0.1g Cyasorb IR 165; 0.1g 2,5-dimethyl-3-hexyne-2,5-diol; and 1.0g of any of the Morfast colors described above. The solution was coated at a loading of 1g of solution/sq.ft. with a #9 Meyer rod by hand drawdown. The dried films are imaged at 0.11 J/cm² on a Crosfield Datrax 765 to give a color print on a receptor sheet and imaged monocolor or black films. The thickness of the dry coating can be adjusted to vary the optical density to a desired level. Optical density differences between the imaged and unimaged areas ranging from 0.5 to 2.0 are typically achieved for the imaged films (transmission density) and for the receptor sheets (reflectance density) when measured using the appropriate color filters on the densitometers.

### EXAMPLE 9

To 9.35g of a 50:50 mixture of 1,1,1-trichloroethane and methylene chloride was added 0.5g of an alternating polycarbonate from Bisphenol A and 2,5-dimethyl-3-hexyne-2,5-diol (Polymer IV from Table 1); 0.1g Cyasorb IR 165; and 0.05g of 2,5-dimethyl-3-hexyne-2,5-diol. The solution was coated on polyester film and imaged at 0.08 J/cm² as described above to give an imaged light tan film and a reversal light tan image on a newsprint receptor sheet.

By comparison films using bisphenol A polycarbonates, polyvinylidene chloride (Saran F120 or F300), polymethacrylonitrile, ethylcellulose N-7, or styrene/acrylonitrile copolymer as binders in the place of decomposable polycarbonate or polyurethanes gave very little or no image transfer to the receptor sheet.

While this invention has been described in terms of various preferred embodiments, the skilled artisan will appreciate that various modifications, substitutions, omissions and changes may be made without departing from the spirit thereof. Accordingly, it is intended that the scope of the present invention be limited solely by the scope of the following claims including equivalents thereof.

## Claims

1. A method for transferring a contrasting pattern of intelligence from an ablation-transfer imaging medium to a receptor element in contiguous registration therewith, said ablation-transfer imaging medium comprising a support substrate and a laser radiation-ablative topcoat essentially coextensive therewith, said essentially coextensive topcoat comprising an effective ablative-transfer effecting amount of a non-black body, non-imaging sensitizer that absorbs near infrared radiation at a rate sufficient to effect the imagewise ablation mass transfer of said topcoat, and said laser radiation-ablative topcoat including at least one decomposable binder and an imaging amount of a non-black body, non-ablation sensitizing contrast imaging material contained therein, which method comprises imagewise photo-irradiating said ablation-transfer imaging medium according to such pattern of intelligence with near infrared radiation at an intensity sufficient to effect the ablation mass transfer of the volume of the imagewise-exposed area of the laser radiation-ablative topcoat of said imaging medium securedly onto said receptor element including mass transfer onto said receptor element of the non-ablation sensitizing contrast imaging material contained therein, and whereby said transferred contrast imaging material delineates said pattern of intelligence thereon.

2. The method as defined by Claim 1, said sensitizer initiating acid formation upon photoexcitation thereof.

3. The method as defined by Claim 1, said sensitizer being substantially colorless in the visible spectral region.

4. The method as defined by Claim 1, said at least one decomposable binder comprising from about 50% to 95% by weight of said essentially coextensive topcoat.

5. The method as defined by Claim 1, said support substrate of said imaging medium comprising glass, a polyester or a polycarbonate.

6. The method as defined by Claim 1, said support substrate of said imaging medium comprising aluminum or silicon.

7. The method as defined by Claim 1, comprising imagewise laser-irradiating said ablation-transfer imaging medium by means of a Nd:YAG laser.

8. The method as defined by Claim 1, comprising imagewise laser-irradiating said ablation-transfer imaging medium by means of a laser diode.

9. The method as defined by Claim 1, said imaging medium being biased in face-to-face registered direct contact with said receptor element.

10. The method as defined by Claim 9, said receptor element comprising a newsprint, paper, plastic, film or metal.

11. The method as defined by Claim 1, comprising transferring a masking pattern of intelligence to said receptor element.

12. The method as defined by Claim 1, comprising transferring a color proof to said receptor element.

13. The method as defined by Claim 12, said receptor element comprising paper.

14. The method as defined by Claim 12, said receptor element comprising a plastic sheet.

15. The method as defined by Claim 12, carried out successively employing a common receptor element but a plurality of ablation-transfer imaging media, the respective ablative topcoats of which including different contrast imaging colorants, and comprising transferring a multi-color proof to said common receptor element.

16. The method as defined by Claim 1, said support substrate of said imaging medium being transparent to near infrared laser irradiation.

17. The method as defined by Claim 1, said support substrate of said imaging medium being opaque to near infrared laser irradiation.

18. The method as defined by Claim 1, said sensitizer comprising an aromatic amine radical cation.

19. The method as defined by Claim 1, said sensitizer comprising a cation radical and an anion of a strong acid.

20. The method as defined by Claim 1, said sensitizer being soluble in said at least one decomposable binder.

21. The method as defined by Claim 1, said at least one decomposable binder being decomposable by acid catalysis.

22. The method as defined by Claim 21, said at least one decomposable binder being adapted for acid catalyzed decomposition at a temperature of less than about 200°C as measured under equilibrium conditions.

23. The method as defined by Claim 22, said at least one decomposable binder comprising a nitrocellulose, polycarbonate, polyurethane, polyester, polyorthoester or polyacetal.

24. The method as defined by Claim 21, said at least one decomposable binder being adapted for acid catalyzed decomposition at a temperature ofless than about 100°C as measured under equilibrium conditions.

25. The method as defined by Claim 21, said essentially coextensive topcoat further comprising an ablation-enhancing amount of at least one hydrogen atom donor that promotes acid formation effecting the acid catalyzed decomposition of said at least one decomposable binder.

26. The method as defined by Claim 25, said at least one hydrogen atom donor comprising an alcohol, thiol, phenol, amine or hydrocarbon.

27. The method as defined by Claim 23, said at least one decomposable binder comprising a nitrocellulose.

28. The method as defined by Claim 23, said at least one decomposable binder comprising a polycarbonate.

29. The method as defined by Claim 28, said polycarbonate comprising recurring structural units of the formula: 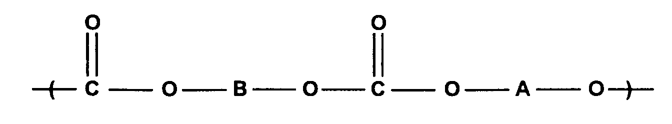 wherein B is a divalent radical generating a tertiary carbonium ion upon thermolysis thereof and A may be identical to B or is the divalent residue of a polycarbonate-forming aromatic dihydroxy or polyhydroxy compound.

30. The method as defined by Claim 29, wherein, in said formula, B is one of the following divalent radicals:

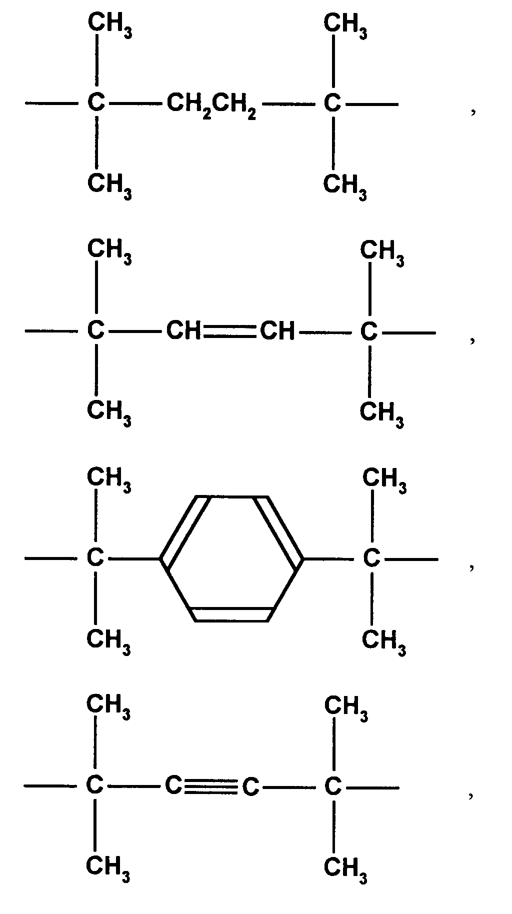

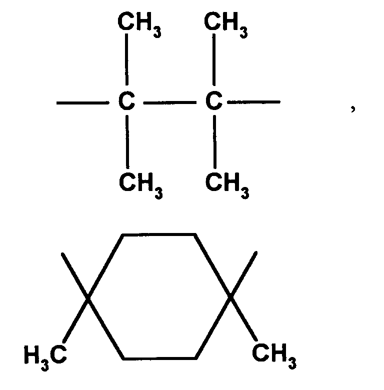

31. The method as defined by Claim 23, said at least one decomposable binder comprising a polyurethane.

32. The method as defined by Claim 31, said polyurethane comprising recurring structural units of the formula: 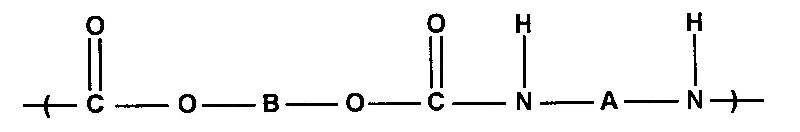 wherein B is a divalent radical generating a tertiary carbonium ion upon thermolysis thereof and A is a divalent residue of a polyurethane-forming diisocyanate or polyisocyanate.

33. The method as defined by Claim 32, wherein, in said formula, B is one of the following divalent radicals:

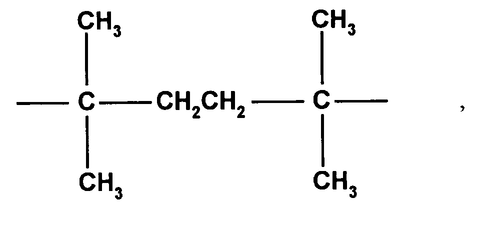

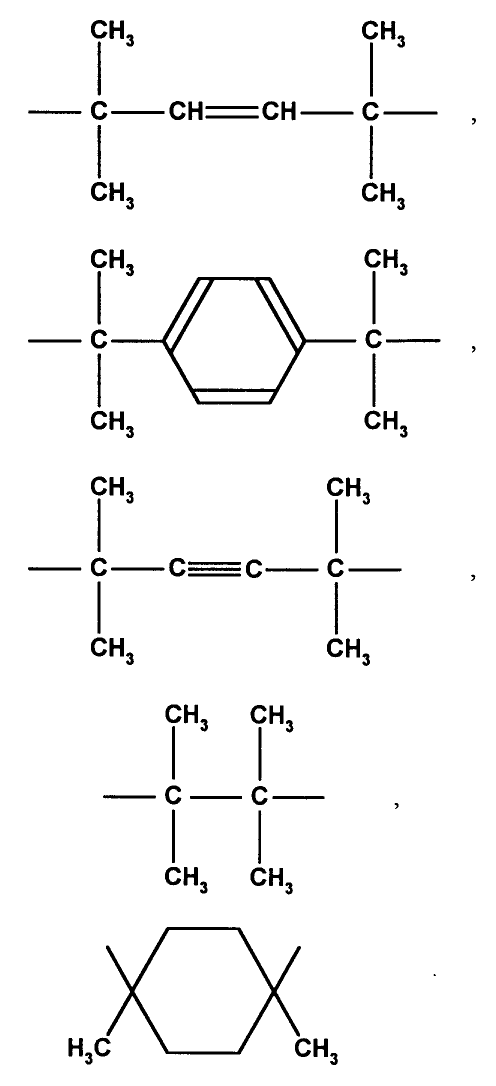

34. The method as defined by Claim 23, said at least one decomposable binder comprising a polyester.

35. The method as defined by Claim 1, said non-black body, non-ablation sensitizing contrast imaging material comprising a colorant, an ultraviolet or infrared absorbing material, a polymeric material or mixture thereof.

36. The method as defined by Claim 35, said non-black body, non-ablation sensitizing contrast imaging material comprising a yellow, magenta or cyan dye or pigment.

37. The method as defined by Claim 1, said sensitizer comprising from about 5% to 50% by weight of said essentially coextensive topcoat.

38. An ablation-transfer imaging medium, which comprises a support substrate and a non-laser radiation-reflecting, laser radiation-ablative topcoat essentially coextensive therewith, said essentially coextensive topcoat comprising an effective ablative-transfer effecting amount of a non-black body, non-imaging sensitizer that absorbs but does not reflect near infrared radiation at a rate sufficient to effect the imagewise ablation mass transfer of said topcoat, and said imaging radiation-ablative topcoat including at least one decomposable binder and an imaging amount of a non-black body, non-ablation sensitizing contrast imaging material contained therein.

39. The ablation-transfer imaging medium as defined by Claim 38, said at least one decomposable binder being decomposable by acid catalysis.

40. The ablation-transfer imaging medium as defined by Claim 39, said essentially coextensive topcoat further comprising at least one hydrogen atom donor for promoting acid formation for said catalyzed decomposition.

41. The ablation-transfer imaging medium as defined by claim 38, said at least one decomposable binder comprising a nitrocellulose, polycarbonate, polyurethane, polyester, polyorthoester or polyacetal.

42. The ablation-transfer imaging medium as defined by Claim 40, said at least one hydrogen atom donor comprising an alcohol, thiol, phenol, amine or hydrocarbon.

43. The ablation-transfer imaging medium as defined by Claim 38, said sensitizer initiating acid formation upon photoexcitation thereof.

44. The ablation-transfer imaging medium as defined by Claim 38, said sensitizer being substantially colorless in the visible spectral region.

45. The ablation-transfer imaging medium as defined by Claim 41, said at least one decomposable binder comprising a nitrocellulose.

46. The ablation-transfer imaging medium as defined by Claim 41, said at least one decomposable binder comprising a polycarbonate.

47. The ablation-transfer imaging medium as defined by Claim 41, said at least one decomposable binder comprising a polyurethane.

48. The ablation-transfer imaging medium as defined by Claim 38, said non-ablation sensitizing contrast imaging material comprising a colorant, an ultraviolet or infrared absorbing material, a polymeric material, or mixture thereof

49. The ablation-transfer imaging medium as defined by Claim 38, said non-ablation sensitizing contrast imaging material comprising a yellow, magenta or cyan dye or pigment.

50. The ablation-transfer imaging medium as defined by Claim 38, said at least one decomposable binder comprising from about 50% to 95% by weight of said essentially coextensive topcoat.

51. The ablation-transfer imaging medium as defined by Claim 50, said sensitizer comprising from about 5% to 50% by weight of said essentially coextensive topcoat.

52. The ablation-transfer imaging medium as defined by Claim 38, said support substrate thereof comprising glass, a polyester or a polycarbonate.

53. The ablation-transfer imaging medium as defined by Claim 38, said support substrate thereof comprising aluminum or silicon.

54. All organization adopted for transferring a contrasting pattern of intelligence from an ablation-transfer imaging medium to a receptor element, comprising (1) an ablation-transfer imaging medium which comprises a support substrate and a non-laser radiation-reflecting, laser radiation-ablative topcoat essentially coextensive therewith, said essentially coextensive topcoat comprising an effective ablative-transfer effecting amount of a non-black body, non-imaging sensitizer that absorbs but does not reflect near infrared radiation at a rate sufficient to effect the imagewise ablation mass transfer of said topcoat, and said laser radiation-ablative topcoat including at least one decomposable binder and an imaging amount of a non-black body, non-ablation sensitizing contrast imaging material contained therein, and (2) a receptor element in contiguous registration therewith.

55. The organization as defined by Claim 54, said at least one decomposable binder being decomposable by acid catalysis.

56. The organization as defined by Claim 55, the essentially coextensive topcoat of said ablation-transfer imaging medium further comprising an ablation-enhancing amount of at least one hydrogen atom donor that promotes acid formation effecting the acid catalyzed decomposition of said at least one decomposable binder.

57. The organization as defined by Claim 54, said ablation-transfer imaging medium being biased in face-to-face registered direct contact with said receptor element.

58. The organization as defined by Claim 54, said receptor element comprising a newsprint, paper, plastic, film, metal or fabric.

59. The organization as defined by Claim 54, said receptor element comprising a light sensitive printing plate.

60. The organization as defined by Claim 54, said receptor element bearing a coating layer of an adhesive or sizing agent.

61. A system for transferring a contrasting pattern of intelligence from an ablation-transfer imaging medium to a receptor element, comprising the organization as defined by Claim 54 and means for selectively irradiating one face surface of said ablation-transfer imaging medium with a beam of laser radiation corresponding to said pattern of intelligence.

## Patentansprüche

1. Verfahren zum Transfer eines kontrastierenden Musters von Information von einem Ablations-Transfer-Abbildemedium auf ein Rezeptorelement in anliegender Registrierung bzw. Eintragung damit, wobei das Ablations-Transfer-Abbildemedium ein Trägersubstrat und einen durch Laserstrahlung abtragbaren bzw. ablativen Decküberzug, der damit im wesentlichen gleichzeitig vorliegt, umfaßt, wobei der gleichzeitig vorhandene Decküberzug eine wirksame, den abtragenden Transfer bzw. den Ablationstransfer bewirkende Menge eines Nichtabbilde-Sensibilisators mit nichtschwarzem Körper umfaßt, der Strahlung im nahen Infrarotbereich mit einer Rate bzw. Geschwindigkeit absorbiert, die ausreichend ist, um einen bildweise erfolgenden Ablations-Massentransfer des genannten Decküberzugs zu bewirken, und wobei der durch Laserstrahlung abtragbare bzw. ablative Decküberzug mindestens ein zersetzbares Bindemittel und eine abbildende Menge eines darin enthaltenen Nichtablations-Sensibilisator-Kontrastabbildungsmaterials mit nichtschwarzem Körper einschließt, wobei dieses Verfahren die bildweise erfolgende Photobestrahlung des genannten Ablations-Transfer-Abbildemediums entsprechend dem Muster von Information mit Strahlung im nahen Infrarotbereich bei einer Intensität, die genügend ist, um den Ablations-Massentransfer des Volumens der bildweise belichteten Fläche des durch Laserstrahlung abtragbaren bzw. ablativen Decküberzugs des genannten Abbildungsmediums gesichert auf das Rezeptorelement mit Einschluß des Massentransfers auf das Rezeptorelement des Nichtablations-Sensibilisator-Kontrastabbildungsmaterials, das darin enthalten ist, zu bewirken, umfaßt und wobei das genannte transferierte Kontrastabbildungsmaterial das genannte Muster von Information darauf skizziert.

2. Verfahren nach Anspruch 1, dadurch **gekennzeichnet,** daß der Sensibilisator die Säurebildung nach seiner Photoerregung initiiert.

3. Verfahren nach Anspruch 1, dadurch **gekennzeichnet,** daß der Sensibilisator im sichtbaren Spektralbereich im wesentlichen farblos ist.

4. Verfahren nach Anspruch 1, dadurch **gekennzeichnet,** daß das zersetzbare Bindemittel etwa 50 bis 95 Gew.-% des im wesentlichen gleichzeitig vorhandenen Decküberzugs umfaßt.

5. Verfahren nach Anspruch 1, dadurch **gekennzeichnet,** daß das Trägersubstrat des Abbildemediums Glas, einen Polyester oder ein Polycarbonat umfaßt.

6. Verfahren nach Anspruch 1, dadurch **gekennzeichnet,** daß das Trägersubstrat des Abbildemediums Aluminium oder Silicium umfaßt.

7. Verfahren nach Anspruch 1, dadurch **gekennzeichnet,** daß es die bildweise erfolgende Laserbestrahlung des Ablations-Transfer-Abbildemediums mittels eines Nd:YAG-Lasers umfaßt.

8. Verfahren nach Anspruch 1, dadurch **gekennzeichnet,** daß es die bildweise erfolgende Laserbestrahlung des Ablations-Transfer-Abbildemediums mittels einer Laserdiode umfaßt.

9. Verfahren nach Anspruch 1, dadurch **gekennzeichnet,** daß das Abbildemedium schräg in Vorderseite-an-Vorderseite-registriertem direktem Kontakt mit dem Rezeptorelement vorhanden ist.

10. Verfahren nach Anspruch 9, dadurch **gekennzeichnet,** daß das Rezeptorelement Zeitungspapier, Papier, Kunststoff, ein Film oder ein Metall umfaßt.

11. Verfahren nach Anspruch 1, dadurch **gekennzeichnet,** daß es den Transfer eines Maskierungsmusters von Information auf das Rezeptorelement umfaßt.

12. Verfahren nach Anspruch 1, dadurch **gekennzeichnet,** daß es den Transfer eines Farbproofs bzw. einer Farbechtheit auf das Rezeptorelement umfaßt.

13. Verfahren nach Anspruch 12, dadurch **gekennzeichnet,** daß das Rezeptorelement Papier umfaßt.

14. Verfahren nach Anspruch 12, dadurch **gekennzeichnet,** daß das Rezeptorelement eine Kunststoffolie umfaßt.

15. Verfahren nach Anspruch 12, dadurch **gekennzeichnet,** daß es unter aufeinanderfolgender VerWendung eines gemeinsamen Rezeptorelements, jedoch einer Mehrzahl von Ablations-Transfer-Abbildemedien, der jeweiligen abtragbaren bzw. ablativen Decküberzüge, die verschiedene Kontrastabbildung-Färbemittel einschließen, durchgeführt wird und daß es den Transfer eines Mehrfarbenproofs bzw. einer Mehrfarbenechtheit an das genannte gemeinsame Rezeptorelement umfaßt.

16. Verfahren nach Anspruch 1, dadurch **gekennzeichnet,** daß das Trägersubstrat des Abbildemediums gegenüber Laserstrahlung im nahen Infrarotbereich transparent ist.

17. Verfahren nach Anspruch 1, dadurch **gekennzeichnet,** daß das Trägersubstrat des Abbildemediums gegenüber Laserstrahlung im nahen Infrarotbereich undurchlässig ist.

18. Verfahren nach Anspruch 1, dadurch **gekennzeichnet,** daß der im nahen Infrarotbereich arbeitende Sensibilisator ein Radikalkation eines aromatischen Amins umfaßt.

19. Verfahren nach Anspruch 1, dadurch **gekennzeichnet,** daß der Sensibilisator ein kationisches Radikal und ein Anion einer starken Säure umfaßt.

20. Verfahren nach Anspruch 1, dadurch **gekennzeichnet,** daß der Sensibilisator in dem zersetzbaren Bindemittel löslich ist.

21. Verfahren nach Anspruch 1, dadurch **gekennzeichnet,** daß das zersetzbare Bindemittel durch Säurekatalyse zersetzbar ist.

22. Verfahren nach Anspruch 21, dadurch **gekennzeichnet,** daß das zersetzbare Bindemittel zur durch Säure katalysierten Zersetzung bei einer Temperatur von weniger als etwa 200°C, gemessen unter Gleichgewichtsbedingungen, angepaßt ist.

23. Verfahren nach Anspruch 22, dadurch **gekennzeichnet,** daß das zersetzbare Bindemittel eine Nitrocellulose, ein Polycarbonat, ein Polyurethan, einen Polyester, einen Polyorthoester oder ein Polyacetal umfaßt.

24. Verfahren nach Anspruch 21, dadurch **gekennzeichnet,** daß das zersetzbare Bindemittel zur durch Säure katalysierten Zersetzung bei einer Temperatur von weniger als etwa 100°C, gemessen unter Gleichgewichtsbedingungen, angepaßt ist.

25. Verfahren nach Anspruch 21, dadurch **gekennzeichnet,** daß der im wesentlichen gleichzeitig vorhandene Decküberzug weiterhin eine ablationsverstärkende Menge von mindestens einem Donator für Wasserstoffatome umfaßt, der die Säurebildung fördert und die durch Säure katalysierte Zersetzung des zersetzbaren Bindemittels bewirkt.

26. Verfahren nach Anspruch 25, dadurch **gekennzeichnet,** daß der Donator für Wasserstoffatome einen Alkohol, ein Thiol, ein Phenol, ein Amin oder einen Kohlenwasserstoff umfaßt.

27. Verfahren nach Anspruch 23, dadurch **gekennzeichnet,** daß das zersetzbare Bindemittel eine Nitrocellulose umfaßt.

28. Verfahren nach Anspruch 23, dadurch **gekennzeichnet,** daß das zersetzbare Bindemittel ein Polycarbonat umfaßt.

29. Verfahren nach Anspruch 28, dadurch **gekennzeichnet,** daß das Polycarbonat Repetier-Struktureinheiten der Formel: 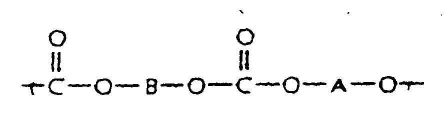 umfaßt, wobei B für einen zweiwertigen Rest steht, der ein tertiäres Carboniumion nach seiner Thermolyse erzeugt, und A mit B identisch sein kann oder den zweiwertigen Rest einer ein Polycarbonat bildenden aromatischen Dihydroxy- oder Polyhydroxyverbindung darstellt.

30. Verfahren nach Anspruch 29, dadurch **gekennzeichnet,** daß die Formel B einer der folgenden zweiwertigen Reste: 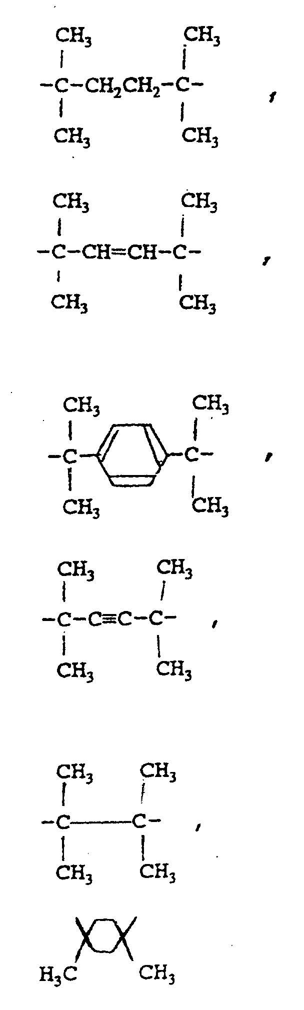 angibt.

31. Verfahren nach Anspruch 23, dadurch **gekennzeichnet,** daß das zersetzbare Bindemittel ein Polyurethan umfaßt.

32. Verfahren nach Anspruch 31, dadurch **gekennzeichnet,** daß das Polyurethan Repetier-Struktureinheiten der Formel: 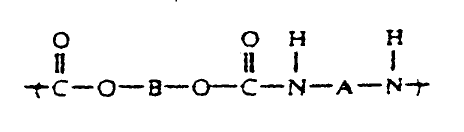 umfaßt, wobei B für einen zweiwertigen Rest steht, der ein tertiäres Carboniumion nach seiner Thermolyse erzeugt, und A den zweiwertigen Rest eines ein Polyurethan bildenden Diisocyanats oder Polyisocyanats darstellt.

33. Verfahren nach Anspruch 32, dadurch **gekennzeichnet,** daß die Formel B einen der folgenden zweiwertigen Reste: 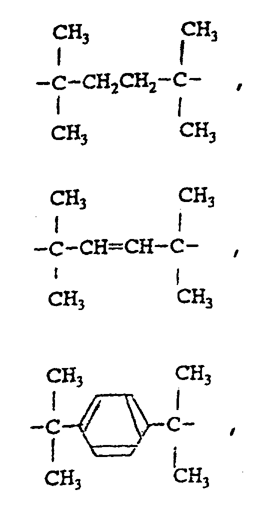 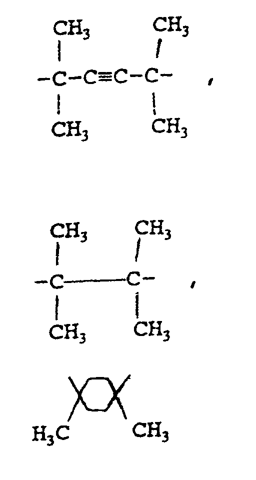 angibt.

34. Verfahren nach Anspruch 23, dadurch **gekennzeichnet,** daß das zersetzbare Bindemittel einen Polyester umfaßt.

35. Verfahren nach Anspruch 1, dadurch **gekennzeichnet,** daß das Nichtablations-Sensibilisator-Kontrastabbildungsmaterial mit nichtschwarzem Körper ein Färbemittel, ein im Ultraviolett- oder Infrarotbereich absorbierendes Material, ein polymeres Material oder ein Gemisch davon umfaßt.

36. Verfahren nach Anspruch 35, dadurch **gekennzeichnet,** daß das Nichtablations-Sensibilisator-Kontrastabbildungsmaterial mit nichtschwarzem Körper einen bzw. ein Gelb-, Magenta- oder Cyan-Farbstoff oder -Pigment umfaßt.

37. Verfahren nach Anspruch 1, dadurch **gekennzeichnet,** daß der Sensibilisator etwa 5 bis 50 Gew.-% des im wesentlichen gleichzeitig vorhandenen Decküberzugs umfaßt.

38. Ablations-Transfer-Abbildemedium, umfassend ein Trägersubstrat und einen Laserstrahlung nicht reflektierenden, durch Laserstrahlung abtragbaren bzw. ablativen Decküberzug, der damit im wesentlichen gleichzeitig vorhanden ist, wobei der im wesentlichen gleichzeitig vorhandene Decküberzug eine wirksame, den abtragenden bzw. ablativen Transfer bewirkende Menge eines Nichtabbilde-Sensibilisators mit nichtschwarzem Körper umfaßt, der Laserstrahlung im nahen Infrarotbereich mit genügender Geschwindigkeit bzw. Rate absorbiert, aber nicht reflektiert, daß der bildweise erfolgende Ablations-Massentransfer des genannten Decküberzugs bewirkt wird, und wobei der durch Abbildestrahlung abtragbare bzw. ablative Decküberzug mindestens ein zersetzbares Bindemittel und eine abbildende Menge eines Nichtablations-Sensibilisator-Kontrastabbildungsmaterials mit nichtschwarzem Körper, das darin enthalten ist, einschließt.

39. Ablations-Transfer-Abbildemedium nach Anspruch 38, dadurch **gekennzeichnet,** daß das zersetzbare Bindemittel durch saure Katalyse zersetzbar ist.

40. Ablations-Transfer-Abbildemedium nach Anspruch 39, dadurch **gekennzeichnet,** daß der im wesentlichen gleichzeitig vorhandene Decküberzug weiterhin mindestens einen Donator für Wasserstoffatome zur Förderung der Säurebildung für die genannte katalysierte Zersetzung umfaßt.

41. Ablations-Transfer-Abbildemedium nach Anspruch 38, dadurch **gekennzeichnet,** daß das zersetzbare Bindemittel eine Nitrocellulose, ein Polycarbonat, ein Polyurethan, einen Polyester, einen Polyorthoester oder ein Polyacetal umfaßt.

42. Ablations-Transfer-Abbildemedium nach Anspruch 40, dadurch **gekennzeichnet,** daß der Donator für Wasserstoffatome ein Alkohol, ein Thiol, ein Phenol, ein Amin oder einen Kohlenwasserstoff umfaßt.

43. Ablations-Transfer-Abbildemedium nach Anspruch 38, dadurch **gekennzeichnet,** daß der Sensibilisator die Säurebildung nach seiner Photoerregung initiiert.

44. Ablations-Transfer-Abbildemedium nach Anspruch 38, dadurch **gekennzeichnet,** daß der Sensibilisator im sichtbaren Spektralbereich im wesentlichen farblos ist.

45. Ablations-Transfer-Abbildemedium nach Anspruch 41, dadurch **gekennzeichnet,** daß das zersetzbare Bindemittel eine Nitrocellulose umfaßt.

46. Ablations-Transfer-Abbildemedium nach Anspruch 41, dadurch **gekennzeichnet,** daß das zersetzbare Bindemittel ein Polycarbonat umfaßt.

47. Ablations-Transfer-Abbildemedium nach Anspruch 41, dadurch **gekennzeichnet,** daß das zersetzbare Bindemittel ein Polyurethan umfaßt.

48. Ablations-Transfer-Abbildemedium nach Anspruch 38, dadurch **gekennzeichnet,** daß das Nichtablations-Sensibilisator-Kontrastabbildungsmaterial ein Färbemittel, ein im Ultraviolett- oder Infrarotbereich absorbierendes Material, ein polymeres Material oder ein Gemisch davon umfaßt.

49. Ablations-Transfer-Abbildemedium nach Anspruch 38, dadurch **gekennzeichnet,** daß das Nichtablations-Sensibilisator-Kontrastabbildungsmaterial einen bzw. ein Gelb-, Magenta- oder Cyan-Farbstoff oder -Pigment umfaßt.

50. Ablations-Transfer-Abbildemedium nach Anspruch 38, dadurch **gekennzeichnet,** daß das zersetzbare Bindemittel etwa 50 bis 95 Gew.-% des im wesentlichen gleichzeitig vorhandenen Decküberzugs umfaßt.

51. Ablations-Transfer-Abbildemedium nach Anspruch 50, dadurch **gekennzeichnet,** daß der Sensibilisator etwa 5 bis 50 Gew.-% des im wesentlichen gleichzeitig vorhandenen Decküberzugs umfaßt.

52. Ablations-Transfer-Abbildemedium nach Anspruch 38, dadurch **gekennzeichnet,** daß sein Trägersubstrat Glas, einen Polyester oder ein Polycarbonat umfaßt.

53. Ablations-Transfer-Abbildemedium nach Anspruch 38, dadurch **gekennzeichnet,** daß sein Trägersubstrat Aluminium oder Silicium umfaßt.

54. Organisation zum Transfer eines kontrastierenden Musters von Information von einem Ablations-Transfer-Abbildemedium auf ein Rezeptorelement, umfassend (1) ein Ablations-Transfer-Abbildemedium, umfassend ein Trägersubstrat und einen Laserstrahlung nicht reflektierenden, durch Laserstrahlung abtragbaren bzw. ablativen Decküberzug, der damit im wesentlichen gleichzeitig vorhanden ist, wobei der im wesentlichen gleichzeitig vorhandene Decküberzug eine wirksame, den abtragenden bzw. ablativen Transfer bewirkende Menge eines Nichtabbilde-Sensibilisators mit nichtschwarzem Körper umfaßt, der Laserstrahlung im nahen Infrarotbereich mit einer genügenden Geschwindigkeit bzw. Rate absorbiert, aber nicht reflektiert, daß der bildweise erfolgende Ablations-Massentransfer des genannten Decküberzugs bewirkt wird, und wobei der durch Laserstrahlung abtragbare bzw. ablative Decküberzug mindestens ein zersetzbares Bindemittel und eine abbildende Menge eines Nichtablations-Sensibilisator-Kontrastabbildungsmaterials mit nichtschwarzem Körper, das darin enthalten ist, umfaßt, und (2) ein Rezeptorelement, das damit in angrenzender Registrierung vorliegt.

55. Organisation nach Anspruch 54, dadurch **gekennzeichnet,** daß das zersetzbare Bindemittel durch saure Katalyse zersetzbar ist.

56. Organisation nach Anspruch 55, dadurch **gekennzeichnet,** daß der im wesentlichen gleichzeitig vorhandene Decküberzug des Ablations-Transfer-Abbildemediums weiterhin eine die Ablation verstärkende Menge von mindestens einem Donator für Wasserstoffatome umfaßt, der die Säurebildung fördert, die die säurekatalysierte Zersetzung des zersetzbaren Bindemittels bewirkt.

57. Organisation nach Anspruch 54, dadurch **gekennzeichnet,** daß das Ablations-Transfer-Abbildemedium schräg in Vorderseite-an-Vorderseite-registriertem direktem Kontakt mit dem Rezeptorelement vorliegt.

58. Organisation nach Anspruch 54, dadurch **gekennzeichnet,** daß das Rezeptorelement ein Zeitungspapier, ein Papier, ein Kunststoff, ein Film, ein Metall oder ein Stoff ist.

59. Organisation nach Anspruch 54, dadurch **gekennzeichnet,** daß das Rezeptorelement eine lichtempfindliche Druckplatte umfaßt.

60. Organisation nach Anspruch 54, dadurch **gekennzeichnet,** daß das Rezeptorelement eine Überzugsschicht aus einem Klebstoff oder Schlichtmittel trägt.

61. System zum Transfer eines kontrastierenden Musters von Information von einem Ablations-Transfer-Abbildemedium auf ein Rezeptorelement, umfassend die Organisation nach Anspruch 54 und Einrichtungen zur selektiven Bestrahlung einer Vorderseiten-Oberfläche des genannten Ablations-Transfer-Abbildemediums mit einem Bündel einer Laserstrahlung entsprechend dem genannten Muster von Information.

## Revendications

1. Procédé pour transférer un modèle de contraste d'information à partir d'un support de formation d'images à transfert ablatif sur un élément récepteur en enregistrement contigu avec celui-ci, ledit support de formation d'images à transfert ablatif comprenant un substrat porteur et une couche supérieure ablative par rayonnement laser essentiellement de même étendue, ladite couche supérieure essentiellement de même étendue comprenant un sensibilisateur non formateur d'images, qui n'est pas un corps noir, en quantité permettant d'effectuer le transfert ablatif, lequel sensibilisateur absorbe le rayonnement proche infrarouge à une vitesse suffisante pour effectuer le transfert de masse ablatif selon l'image de ladite couche supérieure, ladite couche supérieure ablative au rayonnement laser contenant au moins un liant susceptible d'être décomposé et une quantité d'une substance de contraste de formation d'images qui n'est pas sensibilisante pour l'ablation et qui n'est pas un corps noir, ce procédé comprenant le photo-éclairement selon une image de ce support de formation d'images à transfert ablatif selon ledit modèle d'information, avec le rayonnement proche infrarouge à une intensité suffisante pour réaliser le transfert de masse ablatif du volume de la surface exposée selon une image de la couche supérieure ablative au rayonnement laser du support de formation d'images sur l'élément récepteur, comprenant le transfert de masse sur ledit élément récepteur de la substance de contraste de formation d'images qui n'est pas sensibilisante pour l'ablation, de sorte que ladite substance de contraste de formation d'images transférée y dessine ledit modèle d'information.

2. Procédé selon la revendication 1, dans lequel ledit sensibilisateur amorce la formation d'un acide lors de sa photo-excitation.

3. Procédé selon la revendication 1, dans lequel ledit sensibilisateur est essentiellement incolore dans la région du spectre visible.

4. Procédé selon la revendication 1, dans lequel ledit au moins un liant susceptible d'être décomposé comprend d'environ 50 % à 95 % en poids de ladite couche de finition essentiellement de même étendue.

5. Procédé selon la revendication 1, dans lequel ledit substrat porteur dudit support de formation d'images comprend du verre, un polyester ou un polycarbonate.

6. Procédé selon la revendication 1, dans lequel ledit substrat porteur dudit support de formation d'images comprend de l'aluminium ou du silicium.

7. Procédé selon la revendication 1, comprenant l'éclairement par un laser selon une image dudit support de formation d'images à transfert ablatif, au moyen d'un laser Nd:YAG.

8. Procédé selon la revendication 1, comprenant l'éclairement par un laser selon une image dudit support de formation d'images à transfert ablatif, au moyen d'une diode laser.

9. Procédé selon la revendication 1, dans lequel ledit support de formation d'images est amené au contact direct face à face, en registre, avec ledit élément récepteur.

10. Procédé selon la revendication 9, dans lequel ledit élément récepteur comprend un papier journal, un papier, une matière plastique, un film ou un métal.

11. Procédé selon la revendication 1, comprenant le transfert d'un motif de masquage de l'information sur ledit élément récepteur.

12. Procédé selon la revendication 1, comprenant le transfert d'une épreuve couleur sur ledit élément récepteur.

13. Procédé selon la revendication 12, dans lequel ledit élément récepteur comprend du papier.

14. Procédé selon la revendication 12, dans lequel ledit élément récepteur comprend une feuille de matière plastique.

15. Procédé selon la revendication 12, mis en oeuvre en employant successivement un élément récepteur courant, et plusieurs supports de formation d'images à transfert ablatif, dont les couches de finition ablatives respectives contiennent différents colorants de formation d'images à contraste, et comprenant le transfert d'une épreuve polychrome sur ledit élément récepteur courant.

16. Procédé selon la revendication 1, dans lequel ledit substrat porteur dudit support de formation d'images est transparent aux rayonnements laser dans le proche infrarouge.

17. Procédé selon la revendication 1, dans lequel ledit substrat porteur dudit support de formation d'images est opaque aux rayonnements laser, dans le proche infrarouge.

18. Procédé selon la revendication 1, dans lequel ledit sensibilisateur comprend un cation d'un radical aminé aromatique.

19. Procédé selon la revendication 1, dans lequel ledit sensibilisateur comprend un radical cationique et un anion d'un acide fort.

20. Procédé selon la revendication 1, dans lequel ledit sensibilisateur est soluble dans ledit au moins un liant susceptible d'être décomposé.

21. Procédé selon la revendication 1, dans lequel ledit au moins un liant susceptible d'être décomposé est susceptible d'être décomposé par catalyse acide.

22. Procédé selon la revendication 21, dans lequel ledit au moins un liant susceptible d'être décomposé est adapté pour une décomposition catalysée par un acide à une température inférieure à environ 200°C, mesurée dans des conditions d'équilibre.

23. Procédé selon la revendication 22, dans lequel ledit au moins un liant susceptible d'être décomposé comprend une nitrocellulose, un polycarbonate, un polyuréthanne, un polyester, un polyorthoester ou un polyacétal.

24. Procédé selon la revendication 21, dans lequel ledit au moins un liant susceptible d'être décomposé est adapté pour une décomposition catalysée par un acide à une température inférieure à environ 100°C, mesurée dans des conditions d'équilibre.

25. Procédé selon la revendication 21, dans lequel ladite couche de finition essentiellement de même étendue comprend, en outre, une quantité améliorant l'ablation d'au moins un donneur d'atome d'hydrogène, favorisant la formation d'acide effectuant la décomposition catalysée par un acide dudit au moins un liant susceptible d'être décompose.

26. Procédé selon la revendication 25, dans lequel ledit au moins un donneur d'atome d'hydrogène comprend un alcool, un thiol, un phénol, une amine ou un hydrocarbure.

27. Procédé selon la revendication 23, dans lequel ledit au moins un liant susceptible d'être décomposé comprend une nitrocellulose.

28. Procédé selon la revendication 23, dans lequel ledit au moins un liant susceptible d'être décomposé comprend un polycarbonate.

29. Procédé selon la revendication 28, dans lequel ledit polycarbonate comprend des motifs structurels récurrents de formule : 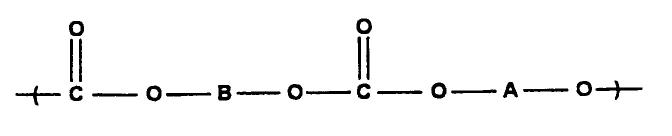 dans laquelle B est un radical divalent produisant un ion carbonium tertiaire par thermolyse, et A peut être identique à B, ou est le résidu divalent d'un composé dihydroxylé ou polyhydroxylé aromatique, formant un polycarbonate.

30. Procédé selon la revendication 29, dans lequel ladite formule B représente un des radicaux divalents suivants :

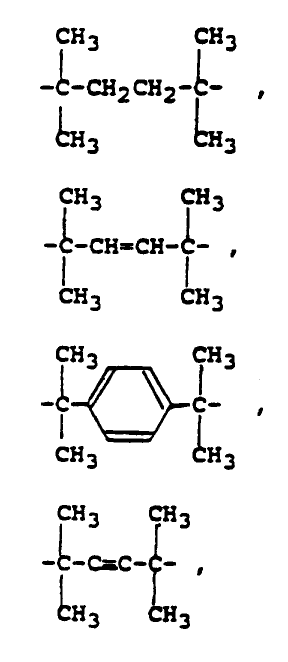

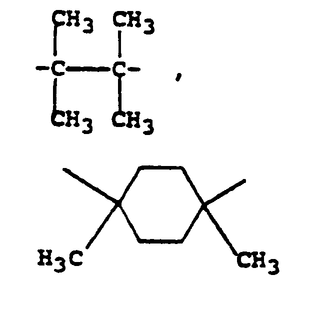

31. Procédé selon la revendication 23, dans lequel ledit au moins un liant susceptible d'être décomposé comprend un polyuréthanne.

32. Procédé selon la revendication 31, dans lequel ledit polyuréthanne comprend des motifs structurels récurrents de formule : 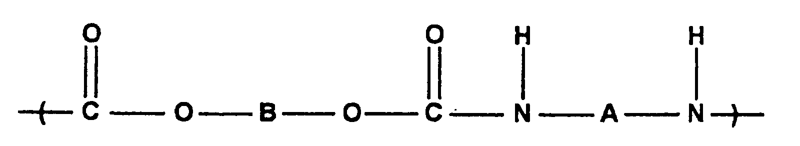 dans laquelle B est un radical divalent, produisant un ion carbonium tertiaire par thermolyse, et A est un résidu divalent d'un diisocyanate ou polyisocyanate formant un polyuréthanne.

33. Procédé selon la revendication 32, dans lequel ladite formule B représente un des radicaux divalents suivants :

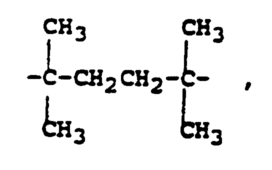

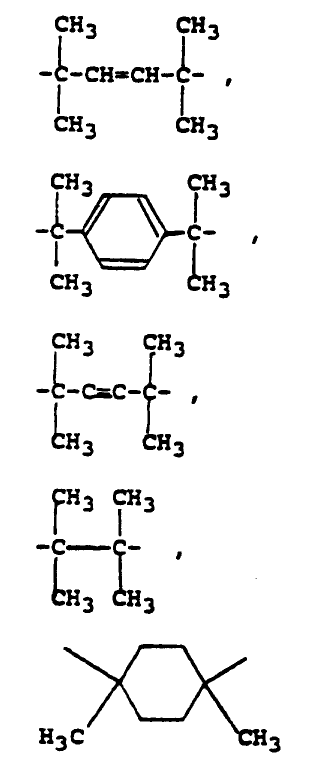

34. Procédé selon la revendication 23, dans lequel ledit au moins un liant susceptible d'être décomposé comprend un polyester.

35. Procédé selon la revendication 1, dans lequel ladite substance de contraste formatrice d'images, qui n'est pas sensibilisante pour l'ablation et qui n'est pas un corps noir, comprend un colorant, une substance absorbant les ultraviolets ou les infrarouges, une matière polymère ou un mélange de celles-ci.

36. Procédé selon la revendication 35, dans lequel ladite substance de contraste formatrice d'images, qui n'est pas sensibilisante pour l'ablation et qui n'est pas un corps noir, comprend un colorant ou un pigment jaune, magenta ou cyan.

37. Procédé selon la revendication 1, dans lequel ledit sensibilisateur comprend d'environ 5 % à 50 % en poids de ladite couche de finition essentiellement de même étendue.

38. Support de formation d'images à transfert ablatif, qui comprend un substrat porteur et une couche de finition essentiellement de même étendue, ablative au rayonnement laser, ne réfléchissant pas ce rayonnement laser, ladite couche de finition essentiellement de même étendue, comprenant une quantité efficace pour réaliser le transfert ablatif d'un sensibilisateur non formateur d'images mais qui n'est pas un corps noir, qui absorbe mais qui ne réfléchit pas le rayonnement proche infrarouge à une vitesse suffisante pour effectuer le transfert de masse ablatif selon l'image de ladite couche de finition, celle-ci contenant au moins un liant susceptible d'être décomposé et une quantité formatrice d'images d'une substance de contraste qui n'est pas sensibilisante pour l'ablation.

39. Support de formation d'images à transfert ablatif selon la revendication 38, dans lequel ledit au moins un liant susceptible d'être décomposé est susceptible d'être décomposé par catalyse acide.

40. Support de formation d'images à transfert ablatif selon la revendication 39, dans lequel ladite couche de finition essentiellement de même étendue comprend, en outre, au moins un donneur d'atome d'hydrogène, favorisant la formation d'acide pour ladite décomposition catalysée par un acide.

41. Support de formation d'images à transfert ablatif selon la revendication 38, dans lequel ledit au moins un liant susceptible d'être décomposé comprend une nitrocellulose, un polycarbonate, un polyuréthanne, un polyester, un polyorthoester ou un polyacétal.

42. Support de formation d'images à transfert ablatif selon la revendication 40, dans lequel ledit au moins un donneur d'atome d'hydrogène comprend un alcool, un thiol, un phénol, une amine ou un hydrocarbure.

43. Support de formation d'images à transfert ablatif selon la revendication 38, dans lequel ledit sensibilisateur amorce la formation d'un acide, lors de sa photo-excitation.

44. Support de formation d'images à transfert ablatif selon la revendication 38, dans lequel ledit sensibilisateur est essentiellement incolore, dans la région du spectre visible.

45. Support de formation d'images à transfert ablatif selon la revendication 41, dans lequel ledit au moins un liant susceptible d'être décomposé comprend une nitrocellulose.

46. Support de formation d'images à transfert ablatif selon la revendication 41, dans lequel ledit au moins un liant susceptible d'être décomposé comprend un polycarbonate.

47. Support de formation d'images à transfert ablatif selon la revendication 41, dans lequel ledit au moins un liant susceptible d'être décomposé comprend un polyuréthanne.

48. Support de formation d'images à transfert ablatif selon la revendication 38, dans lequel ladite substance de contraste formatrice d'images, qui n'est pas sensibilisante pour l'ablation, comprend un colorant, une substance absorbant les ultraviolets ou les infrarouges, une matière polymère ou un mélange de celles-ci.

49. Support de formation d'images à transfert ablatif selon la revendication 38, dans lequel ladite substance de contraste formatrice d'images, qui n'est pas sensibilisante pour l'ablation, comprend un colorant ou un pigment jaune, magenta ou cyan.

50. Support de formation d'images à transfert ablatif selon la revendication 38, dans lequel ledit au moins un liant susceptible d'être décomposé comprend d'environ 50 % à 95 % en poids de ladite couche de finition, essentiellement de même étendue.

51. Support de formation d'images à transfert ablatif selon la revendication 50, dans lequel ledit sensibilisateur comprend d'environ 5 % à 50 % en poids de ladite couche de finition essentiellement de même étendue.

52. Support de formation d'images à transfert ablatif selon la revendication 38, dans lequel ledit substrat porteur du support comprend du verre, un polyester ou un polycarbonate.

53. Support de formation d'images à transfert ablatif selon la revendication 38, dans lequel ledit substrat porteur du support comprend de l'aluminium ou du silicium.

54. Organisation adoptée pour transférer un modèle contrastant d'information d'un support de formation d'images à transfert ablatif, sur un élément récepteur, comprenant (1) un support de formation d'images à transfert ablatif qui comprend un substrat porteur et une couche de finition ablative par rayonnement laser, ne réfléchissant pas le rayonnement laser, essentiellement de même étendue que le support, ladite couche supérieure comprenant une quantité efficace pour réaliser le transfert ablatif d'un sensibilisateur non formateur d'images, qui n'est pas un corps noir, qui absorbe mais qui ne réfléchit pas le rayonnement proche infrarouge à une vitesse suffisante pour effectuer le transfert de masse ablatif selon l'image de ladite couche supérieure, celle-ci contenant au moins un liant susceptible d'être décomposé et une quantité formatrice d'images d'une substance de contraste qui n'est pas sensibilisante pour l'ablation et qui n'est pas un corps noir, et (2) un élément récepteur, en registre contigu avec ce support.

55. Organisation selon la revendication 54, dans laquelle ledit au moins un liant susceptible d'être décomposé est susceptible d'être décomposé par catalyse acide.

56. Organisation selon la revendication 55, dans laquelle la couche de finition essentiellement de même étendue du support de formation d'images à transfert ablatif comprend, en outre, une quantité favorisant l'ablation d'au moins un donneur d'atome d'hydrogène, favorisant la formation d'acide effectuant ladite décomposition catalysée par un acide dudit au moins un liant susceptible d'être décompose.

57. Organisation selon la revendication 54, dans laquelle ledit support de formation d'images à transfert ablatif est amené au contact direct face à face, en registre, avec ledit élément récepteur.

58. Organisation selon la revendication 54, dans laquelle ledit élément récepteur comprend un papier journal, un papier, une matière plastique, un film, un métal ou un tissu.

59. Organisation selon la revendication 54, dans laquelle ledit élément récepteur comprend une plaque d'impression photosensible.

60. Organisation selon la revendication 54, dans laquelle ledit élément récepteur porte une couche de revêtement, faite d'adhésif ou d'agent d'encollage.

61. Système pour transférer un modèle contrastant d'information d'un support de formation d'images à transfert ablatif sur un élément récepteur, comprenant l'organisation selon la revendication 54 et un moyen pour éclairer sélectivement une des faces du support de formation d'images à transfert ablatif avec le faisceau d'un rayonnement laser, correspondant audit modèle d'information.
